(19) Europäisches Patentamt
European Patent Office
Office européen des brevets

(11) **EP 4 607 165 A1**

(12) **DEMANDE DE BREVET EUROPEEN**

(43) Date de publication:
**27.08.2025 Bulletin 2025/35**

(51) Classification Internationale des Brevets (IPC):
**G01K 1/143** (2021.01)    **G01K 1/16** (2006.01)

(21) Numéro de dépôt: **25305113.0**

(52) Classification Coopérative des Brevets (CPC):
**G01K 1/143; G01K 1/16**

(22) Date de dépôt: **28.01.2025**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **21.02.2024 FR 2401717**

(71) Demandeur: **Nexans**
**92400 Courbevoie (FR)**

(72) Inventeur: **GUFFOND, Raphaël**
**92400 COURBEVOIE (FR)**

(74) Mandataire: **Ipsilon**
**Le Centralis**
**63, avenue du Général Leclerc**
**92340 Bourg-la-Reine (FR)**

(54) **SYSTÈME DE DÉTERMINATION NON-INVASIVE D'UNE TEMPÉRATURE D'UN CONDUCTEUR D'UN CÂBLE ÉLECTRIQUE**

(57) L'invention concerne un système de détermination (100) non-invasive d'une température d'un conducteur d'un câble électrique, comprenant :
- un câble électrique (10) comprenant au moins un conducteur électrique (12) et au moins une couche de matériau (14, 16) entourant ledit au moins un conducteur, ladite au moins une couche présentant une résistance thermique de couche $T_1$,
- au moins un capteur de température (20) disposé sur une surface externe (18) de ladite au moins une couche de matériau pour mesurer une température périphérique $\Theta_{b1}$ au niveau de la surface externe de ladite au moins une couche de matériau,
- une unité de détermination (22) configurée pour déterminer une température de conducteur $\Theta_{cond}$ en fonction de la température périphérique $\Theta_{b1}$ mesurée, la résistance thermique de couche $T_1$ et le flux thermique $W_c$ généré par la circulation d'un courant électrique dans le conducteur électrique.

[Fig. 2]

FIG.2

## Description

### Domaine technique

La présente invention concerne un système de détermination de la température d'un conducteur électrique d'un câble électrique.

Plus spécifiquement, l'invention concerne un système de détermination non-invasif.

### Arrière-plan technologique

Lors de la phase de test ou de l'utilisation d'un câble électrique, il est important de connaître la température du conducteur du câble électrique de manière à pouvoir suivre le bon fonctionnement de ce même câble ainsi que pour le dimensionner correctement.

Une difficulté réside dans le fait que disposer un capteur de température directement à proximité du conducteur entraine la présence d'un trou ou d'un espace au sein du câble ce qui peut générer des arcs électriques au sein de cet espace.

Pour pallier cette difficulté, il est connu de connecter une portion du câble électrique à une boucle de test formée par un câble de même nature que le câble électrique. Aucune tension n'est appliquée dans la boucle de test et un capteur de température est disposé au contact du conducteur. Ceci permet de suivre la variation de température du conducteur de la boucle de test de manière à estimer la température du conducteur de la portion de câble électrique dans laquelle un courant circule. L'inconvénient de cette méthode est qu'elle ne peut être réalisée que dans une phase de test et non sur un câble électrique installé in situ.

Une autre méthode consiste à disposer une fibre optique à l'intérieur d'un câble électrique le long du conducteur électrique durant la fabrication de ce câble électrique. Cette fibre optique permet de mesurer la température du conducteur. L'inconvénient de cette méthode est qu'elle est invasive cat la présence de la fibre optique requiert une adaptation du câble électrique. De plus, la fibre optique doit être insérée sur la totalité de la longueur du câble ce qui engendre un coût important.

Il existe donc un besoin pour un système de détermination non-invasive d'une température d'un conducteur d'un câble électrique.

### Résumé de l'invention

Pour cela, l'invention propose un système de détermination non-invasive d'une température d'un conducteur d'un câble électrique, comprenant :

- un câble électrique comprenant au moins un conducteur électrique et au moins une couche de matériau entourant ledit au moins un conducteur, ladite au moins une couche présentant une résistance thermique de couche $T_1$,
- au moins un capteur de température disposé sur une surface externe de ladite au moins une couche de matériau pour mesurer une température périphérique $\Theta_{b1}$ au niveau de la surface externe de ladite au moins une couche de matériau,
- une unité de détermination configurée pour déterminer une température de conducteur $\Theta_{cond}$ en fonction de la température périphérique $\Theta_{b1}$ mesurée et la résistance thermique de couche $T_1$.

La détermination de la température de conducteur $\Theta_{cond}$ se fait ici au moyen d'un modèle physique utilisant la température périphérique $\Theta_{b1}$ mesurée et la résistance thermique de couche $T_1$.

L'utilisation de ce modèle physique permet de s'affranchir de l'utilisation d'une température interne au câble électrique, i.e. mesurée via un composant disposé à proximité du conducteur, ou plus généralement à l'intérieur de la gaine externe du câble électrique.

Le modèle physique utilisé permet d'estimer la température de conducteur $\Theta_{cond}$ au moyen de la température périphérique $\Theta_{b1}$ mesurée et la résistance thermique de couche $T_1$.

Selon un mode de réalisation du système de détermination, celui-ci comprend en outre :

- au moins une couche additionnelle de matériau disposée autour de ladite au moins une couche de matériau et recouvrant ledit au moins un capteur de température, ladite couche additionnelle de matériau présentant une résistance thermique additionnelle $T_b$,
- au moins un capteur de température additionnel disposé sur une surface externe de ladite couche de matériau additionnelle pour mesurer une température périphérique additionnelle $\Theta_{b2}$ au niveau de la surface externe de ladite au moins une couche additionnelle de matériau.

Selon un mode de réalisation du système de détermination, ladite couche additionnelle de matériau s'étend autour de ladite au moins une couche de matériau uniquement sur une portion de la longueur du câble électrique.

Selon un mode de réalisation du système de détermination, ladite au moins une couche additionnelle de matériau comprend :

- une première portion de couche additionnelle présentant une première résistance thermique additionnelle $T_b$, et
- une deuxième portion de couche additionnelle présentant une deuxième résistance thermique additionnelle $T'_b$, les première $T_b$ et deuxième $T'_b$ résistances thermiques additionnelles étant différentes,

et dans lequel ledit au moins un capteur de température additionnel comprend :

- au moins un premier capteur de température additionnel disposé sur une surface externe de la première portion de couche additionnelle pour mesurer une première température périphérique additionnelle $\Theta_{b2}$,
- au moins un deuxième capteur de température additionnel disposé sur une surface externe de la deuxième portion de couche additionnelle pour mesurer une deuxième température périphérique additionnelle $\Theta'_{b2}$,

l'unité de détermination étant configurée pour déterminer la température de conducteur $\Theta_{cond}$ en outre en fonction de la première $T_b$ et de la deuxième $T'_b$ résistances thermiques additionnelles ainsi que de la première $\Theta_{b2}$ et de la deuxième $\Theta'_{b2}$ températures périphériques additionnelles.

Selon un mode de réalisation du système de détermination, lesdites au moins une première et au moins une deuxième couches additionnelles sont disposées sur des secteurs angulaires différents autour du conducteur électrique.

Lesdites au moins une première et au moins une deuxième couches additionnelles peuvent se recouvrir au moins partiellement.

Selon un mode de réalisation du système de détermination, lesdites au moins une première et au moins une deuxième couches additionnelles forment ensemble une couche s'étendant de manière continue autour du conducteur électrique dans un plan perpendiculaire à l'axe longitudinal d'extension du conducteur électrique.

Selon un mode de réalisation du système de détermination, ledit au moins un capteur de température comprend :

- au moins un premier capteur disposé sur la surface externe de ladite au moins une couche de matériau, entre ladite surface externe et la première portion de couche additionnelle, pour mesurer une température périphérique $\Theta_{b1}$ au niveau de la surface externe de ladite au moins une couche de matériau,
- au moins un deuxième capteur disposé sur la surface externe de ladite au moins une couche de matériau, entre ladite surface externe et la deuxième portion de couche additionnelle, pour mesurer une température périphérique $\Theta'_{b1}$ au niveau de la surface externe de ladite au moins une couche de matériau.

Selon un mode de réalisation du système de détermination, l'unité de détermination est configurée pour déterminer la température de conducteur $\Theta_{cond}$ sur la base de l'équation suivante :

$$\theta_{conducteur} = \frac{(\theta_{b1}T_b - \theta'_{b1}T'_b) \times ((\theta_{b1} - \theta_{b2}))}{T_b(\theta'_{b1} - \theta'_{b2}) - T'_b(\theta_{b1} - \theta_{b2})}$$

$T_1$ étant la résistance thermique de ladite au moins une couche de matériau, $T_b$ étant la première résistance thermique additionnelle de la première couche additionnelle de matériau,

$T'_b$ étant la deuxième résistance thermique additionnelle de la deuxième couche additionnelle de matériau,

$\Theta_{b1}$ est la température périphérique mesurée par ledit au moins un premier capteur de température,

$\Theta_{b2}$ est la température périphérique additionnelle mesurée par ledit au moins un premier capteur de température additionnel,

$\Theta'_{b1}$ est la température périphérique mesurée par ledit au moins un deuxième capteur de température,

$\Theta'_{b2}$ est la température périphérique additionnelle mesurée par ledit au moins un deuxième capteur de température additionnel.

Selon un mode de réalisation du système de détermination, les première et deuxième portions de couche additionnelle sont réalisées dans un matériau différent.

Selon un mode de réalisation du système de détermination, les première et deuxième portions de couche additionnelle présentent une épaisseur différente, prise perpendiculairement à un axe longitudinal d'extension du câble électrique.

Selon un mode de réalisation du système de détermination, ladite au moins une couche de matériau comprend une gaine externe formant ladite surface externe, ledit au moins un capteur de température étant disposé sur ladite gaine externe.

Selon un mode de réalisation du système de détermination, l'unité de détermination est configurée pour déterminer une température de conducteur $\Theta_{cond}$ en fonction de la température périphérique $\Theta_{b1}$ mesurée et la résistance thermique de couche $T_1$ et le flux thermique $W_c$ généré par la circulation d'un courant électrique dans le conducteur électrique

Selon un mode de réalisation du système de détermination, l'unité de détermination est configurée pour déterminer la température de conducteur $\Theta_{cond}$ en fonction du flux thermique $W_c$ généré par la circulation d'un courant électrique dans le conducteur électrique, sur la base de l'équation suivante :

$$\Theta_{cond} = \Theta_{b1} + W_c{}^*T_1$$

L'unité de détermination peut être disposée à proximité du câble électrique ou à distance de celui-ci.

Selon un mode de réalisation du système de détermination, ladite au moins une couche de matériau comprend une gaine externe formant ladite surface externe, ledit au moins un capteur de température étant disposé sur ladite gaine externe.

Selon un mode de réalisation du système de détermination, celui-ci comprend en outre un dispositif de mesure de l'intensité électrique $I_{cond}$ d'un courant électrique circulant dans ledit au moins un conducteur électrique, l'unité de détermination étant configurée pour déterminer ladite température de conducteur $\Theta_{cond}$ en outre en fonction de cette intensité électrique $I_{cond}$.

Selon un mode de réalisation du système de détermination, le dispositif de mesure est un dispositif non-invasif, notamment du type d'un enroulement de Rogowski.

Selon un mode de réalisation du système de détermination, la température du conducteur Ocond est déterminée comme suit :

$$\Theta_{cond} = \Theta_{b1} + R_c{}^*I_{cond}{}^{2*}T_1$$

$R_c$ étant la résistance électrique du conducteur

Selon un mode de réalisation du système de détermination, celui-ci comprenant en outre :

- une couche additionnelle de matériau disposée autour de ladite au moins une couche de matériau et recouvrant ledit au moins un capteur de température, ladite couche additionnelle de matériau présentant une résistance thermique additionnelle Tb
- au moins un capteur de température additionnel disposé sur une surface externe de ladite couche de matériau additionnelle pour mesurer une température périphérique additionnelle $\Theta_{b2}$ au niveau de la surface externe de ladite au moins une couche additionnelle de matériau.

Selon un mode de réalisation du système de détermination, ladite couche additionnelle de matériau s'étend autour de ladite au moins une couche de matériau uniquement sur une portion de la longueur du câble électrique.

Selon un mode de réalisation du système de détermination, l'unité de détermination est configurée pour déterminer la température de conducteur $\Theta_{cond}$ sur la base de l'équation suivante :

$$\theta_{cond} = \theta_{b1} + \frac{(\theta_{b1} - \theta_{b2})}{T_b} \times T_1$$

$\Theta_{b1}$ est la température périphérique mesurée par ledit au moins un capteur de température,
$\Theta_{b2}$ est la température périphérique additionnelle mesurée par ledit au moins un capteur de température additionnel,
$T_b$ étant la résistance thermique additionnelle de la couche additionnelle de matériau,
$T_1$ étant la résistance thermique de ladite au moins une couche de matériau.

Selon un mode de réalisation du système de détermination, l'unité de détermination est configurée pour déterminer la température de conducteur $\Theta_{cond}$ en outre en fonction d'un échauffement $W_d$ provenant d'une perte diélectrique dans ladite au moins une couche de matériau.

Selon un mode de réalisation du système de détermination, l'unité de détermination est configurée pour déterminer la température de conducteur $\Theta_{cond}$ sur la base de l'équation suivante :

$$\theta_{cond} = \theta_{b1} + T_1 \times \left( W_c - \frac{W_d}{2} \right)$$

$W_d$ étant l'échauffement provenant d'une perte diélectrique dans ladite au moins une couche de matériau.

Selon un mode de réalisation du système de détermination, l'unité de détermination est configurée pour déterminer la température de conducteur $\Theta_{cond}$ sur la base de l'équation suivante :

$$\theta_{cond} = \theta_{b1} + T_1 \times \left( \frac{\theta_{b1} - \theta_{b2}}{T_b} - \frac{W_d}{2} \right)$$

$W_d$ étant l'échauffement provenant d'une perte diélectrique dans ladite au moins une couche de matériau.

Selon un mode de réalisation du système de détermination, celui-ci comprend en outre un boîtier de détermination comprenant l'un ou plusieurs parmi ledit au moins un capteur de température et l'unité de détermination, le boîtier étant configuré pour être monté de manière amovible au câble électrique.

Selon un mode de réalisation du système de détermination, ladite au moins une couche additionnelle de matériau et ledit au moins un capteur de température additionnel sont portés par le boîtier de détermination.

Ce boîtier de détermination est par exemple amovible par rapport au câble électrique de manière à réaliser une mesure ponctuelle et localisée sur le câble électrique. Ce boîtier est par exemple un accessoire de mesure.

Le boîtier de détermination présente une dimension suivant l'axe longitudinal de sorte qu'il s'étend uniquement sur une portion de la longueur du câble électrique.

**Brève description des figures**

La description qui va suivre en regard des dessins annexés, donnés à titre d'exemples non limitatifs, fera bien comprendre en quoi consiste l'invention et comment elle peut être réalisée. Sur les figures annexées :

[fig. 1] La figure 1 représente une vue en coupe d'un câble électrique selon une première configuration comprenant un conducteur électrique et au moins une couche de matériau, le câble électrique appartenant à un système de détermination;

[fig. 2] La figure 2 représente une vue en coupe du câble électrique de la figure 1 comprenant une pluralité de capteurs sur une surface externe de ladite au moins une couche de matériau;

[fig. 3] La figure 3 représente un schéma d'une première modélisation du câble électrique, selon un premier mode de détermination comprenant une détermination de l'intensité électrique du courant électrique circulant dans le conducteur électrique;

[fig. 4] La figure 4 représente une vue en coupe du câble électrique de la figure 1 selon un deuxième mode de détermination dans lequel le système de détermination comprend une couche additionnelle de matériau autour du câble électrique et une pluralité de capteurs additionnels disposés sur une surface externe de cette couche additionnelle de matériau;

[fig. 5] La figure 5 représente un schéma d'une deuxième modélisation du câble électrique selon le deuxième mode de détermination;

[fig. 6] La figure 6 représente une troisième modélisation du câble électrique dans laquelle les pertes diélectriques dans ladite au moins une couche de matériau sont prises en compte, selon le premier mode de détermination;

[fig. 7] La figure 7 représente une quatrième modélisation du câble électrique dans laquelle les pertes diélectriques dans ladite au moins une couche de matériau sont prises en compte, selon le deuxième mode de détermination;

[fig. 8] La figure 8 représente une vue en coupe du câble électrique selon une deuxième configuration comprenant un conducteur électrique, une ou plusieurs couches de matériau entourant le conducteur électrique et un écran entourant lesdites couches de matériau;

[fig. 9] La figure 9 une cinquième modélisation du câble électrique dans laquelle les pertes diélectriques dans ladite au moins une couche de matériau sont prises en compte ainsi que les pertes diélectriques dans l'écran;

[fig. 10] La figure 10 une sixième modélisation du câble électrique pour déterminer la température de conducteur $\Theta_{cond}$ de manière indépendante du milieu environnant;

[fig. 11] La figure 11 représente une vue en perspective d'un mode de réalisation du système de détermination de la figure 1 comprenant un boîtier de détermination monté sur le câble électrique, le boîtier de détermination comprenant un capteur de température et/ou une unité de température ;

[fig. 12] La figure 12 représente une vue en coupe du câble électrique de la figure 4 selon un deuxième mode de détermination dans lequel le système de détermination comprend une couche additionnelle de matériau formée d'une première et d'une deuxième portions de couche additionnelle et une pluralité de capteurs additionnels disposés sur une surface externe de chacune des première et deuxième portions de couche additionnelle de matériau;

[fig. 13] La figure 13 représente un schéma d'une septième modélisation du câble électrique utilisant la première portion de couche additionnelle de la figure 12;

[fig. 14] La figure 14 représente un schéma de la septième modélisation du câble électrique utilisant la deuxième portion de couche additionnelle de la figure 12;

[fig. 15] La figure 15 représente une équation de détermination de la température de conducteur selon la septième modélisation;

[fig. 16] La figure 16 représente un schéma d'une huitième modélisation du câble électrique utilisant la première portion de couche additionnelle de la figure 12;

[fig. 17] La figure 17 représente un schéma de la huitième modélisation du câble électrique utilisant la deuxième portion de couche additionnelle de la figure 12;

[fig. 18] La figure 18 représente une équation de détermination de la température de conducteur selon la huitième modélisation.

## Description de mode(s) de réalisation

Par souci de clarté, les mêmes références désignant les mêmes éléments selon l'état de l'art et selon l'invention sont utilisées pour toutes les figures.

Le concept de l'invention est décrit plus complètement ci-après avec référence aux dessins joints, sur lesquels des modes de réalisation du concept de l'invention sont montrés. Sur les dessins, la taille et les tailles relatives des éléments peuvent être exagérées à des fins de clarté. Des numéros similaires font référence à des éléments similaires sur tous les dessins. Cependant, ce concept de l'invention peut être mis en œuvre sous de nombreuses formes différentes et ne devrait pas être interprété comme étant limité aux modes de réalisation exposés ici. Au lieu de cela, ces modes de réalisation sont proposés de sorte que cette description soit complète, et communiquent l'étendue du concept de l'invention aux hommes du métier.

Une référence dans toute la spécification à « un mode de réalisation » signifie qu'une fonctionnalité, une structure, ou une caractéristique particulière décrite en relation avec un mode de réalisation est incluse dans au moins un mode de réalisation de la présente invention. Ainsi, l'apparition de l'expression « dans un mode de réalisation » à divers emplacements dans toute la spécification ne fait pas nécessairement référence au même mode de réalisation. En outre, les fonctionnalités, les structures, ou les caractéristiques particulières peuvent être combinées de n'importe quelle manière appropriée dans un ou plusieurs modes de réalisation. De plus, le terme « comprenant » n'exclut pas d'autres éléments ou étapes.

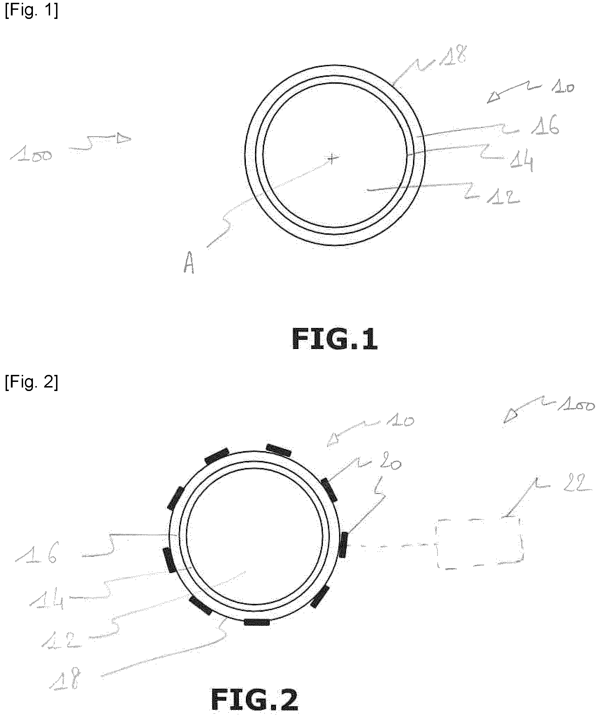

En référence à la figure 1, un câble électrique 10 comprend un conducteur électrique 12, une première couche de matériau 14 autour du conducteur électrique 12 et une deuxième couche de matériau 16 autour de la première couche de matériau 14.

Le conducteur électrique 12 s'étend le long d'un axe longitudinal A.

Les première 14 et deuxième 16 couches de matériau s'étendent le long de l'axe longitudinal A, autour du conducteur électrique 12.

La première couche de matériau 14 est par exemple une couche formée d'un matériau isolant électriquement. La première couche de matériau 14 peut donc être considérée comme une couche isolante.

La deuxième couche de matériau 16 forme ici une couche externe du câble électrique 10. La deuxième couche de matériau 16 forme une surface externe 18 du câble électrique 10.

La deuxième couche de matériau 16 est par exemple une gaine externe.

De manière plus générale, le câble électrique 10 peut comporter une ou plusieurs couches de matériau entourant le conducteur électrique 12. Le câble électrique 10 peut notamment comprendre l'un ou plusieurs parmi : un écran, une couche semi-conductrice, une couche isolante, une gaine externe.

Dans une configuration préférée, le câble électrique 10 comprend autour du conducteur, par ordre de disposition du centre vers la périphérie : une couche semi-conductrice, une couche isolante, un écran et une gaine externe. Cette configuration correspond par exemple à un câble électrique configuré pour un réseau de moyenne tension (entre 1 et 52 kV).

En référence à la figure 2, un système de détermination 100 comprend le câble électrique 10, au moins un capteur de température 20 et une unité de détermination 22.

Le système de détermination 100 peut comprendre une pluralité de capteurs de température 20 répartis autour de l'axe longitudinal A dans un même plan transversal à cet axe longitudinal A. Dans l'exemple de la figure 2, le système de détermination 100 comprend 9 capteurs de température 20.

Le ou les capteurs de température 20 sont configurés pour mesurer une température périphérique $\Theta_{b1}$. Dans cette configuration où les capteurs de température 20 sont disposés au niveau de la surface externe 18 du câble électrique, la température périphérique $\Theta_{b1}$ correspond à la température en surface du câble électrique 10.

Le ou les capteurs de température 20 sont connectés à l'unité de détermination 22 de manière à communiquer la température périphérique $\Theta_{b1}$ à cette unité de détermination 22.

De préférence, les capteurs de température 20 sont équirépartis autour de l'axe longitudinal A. Le système de détermination 100 peut prévoir un ou plusieurs capteurs de température 20 répartis en outre le long de l'axe longitudinal A de manière à mesurer la température périphérique $\Theta_{b1}$ à différentes localisations le long du câble électrique 10.

Cette unité de détermination 22 est configurée pour déterminer la température de conducteur $\Theta_{cond}$, i.e. la température du conducteur électrique 12.

Cette détermination est réalisée de manière non-invasive et non-destructrice. Ainsi, aucun composant n'est inséré sous les couches de matériau ou à proximité du conducteur électrique 12 pour déterminer sa température de conducteur $\Theta_{cond}$. De plus, aucune couche de matériau du câble électrique 10 n'est endommagée ou transpercée pour réaliser cette détermination. Aucun composant tiers n'est intégré à la fabrication du câble électrique 10 telle qu'une fibre optique ou un capteur dans l'une des couches du câble électrique 10 ou bien entre ces couches de matériau.

On entend plus généralement par « non-invasif » ou « non-destructrif » le fait que la structure initiale du câble n'est pas modifiée. Cette structure initiale du câble correspond à la structure du câble dépourvue d'unité de détermination de la température ou, plus généralement, d'un dispositif de détermination de la température du conducteur électrique.

Ceci permet de réaliser une détermination de la température de conducteur sur un câble électrique existant, par exemple déjà installé in situ, sans avoir la nécessité de l'endommager ou d'y insérer un quelconque outil de mesure.

On considère ici que l'adjonction de composants de mesure ou de couches de matériau supplémentaires n'est pas invasif ou destructif.

L'unité de détermination 22 utilise un modèle physique permettant de déterminer la température de conducteur $\Theta_{cond}$ en fonction de la température périphérique $\Theta_{b1}$ mesurée par le ou les capteurs de température 20.

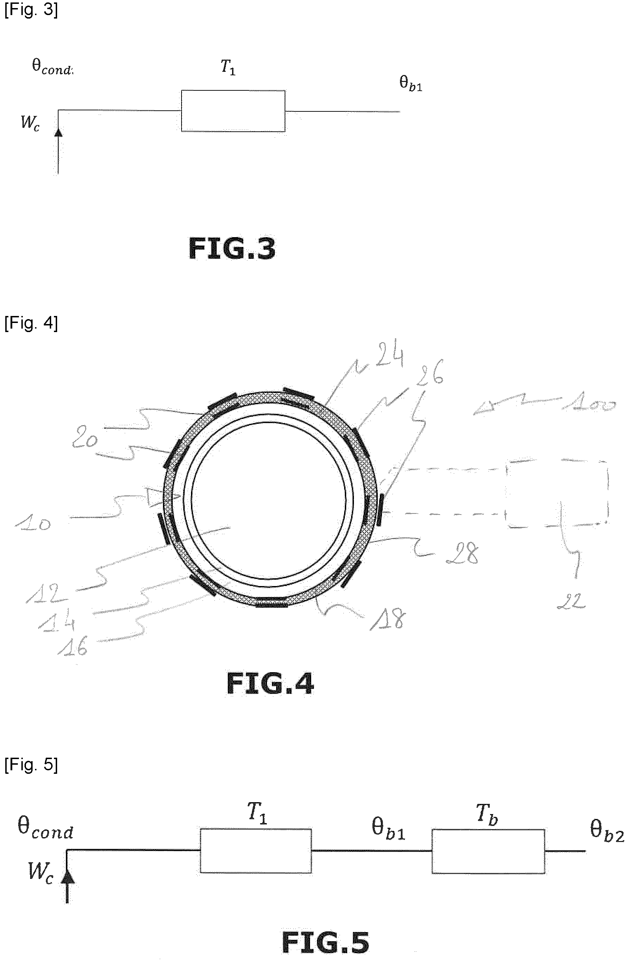

En référence à la figure 3, la diffusion de la chaleur au travers du câble électrique 10 est représentée sous forme de schéma pour illustrer le modèle physique utilisé par l'unité de détermination 22.

Ce modèle physique repose sur le fait que la diffusion de la chaleur au travers des couches d'un câble électrique suit un comportement proche de celui de la circulation d'un courant au sein d'un circuit électrique comportant une résistance électrique.

Ainsi, le modèle physique établit une relation entre la résistance thermique T1 de ladite au moins une couche de matériau. La résistance thermique $T_1$ peut correspondre à la résistance thermique de l'une ou plusieurs des couches de matériau. Dans l'exemple de la figure 2, la résistance thermique $T_1$ représente la résistance thermique de l'ensemble des première 14 et deuxième 16 couches de matériau. Pour ce modèle physique, les première 14 et deuxième 16 couches de matériau forment donc une seule et même couche de matériau présentant une résistance thermique de couche, appelée $T_1$.

Le passage du courant à l'intérieur du conducteur génère un échauffement induisant un flux thermique $W_c$.

Dans ce modèle physique, la différence de tension $\Delta U$ aux bornes d'une résistance électrique est rapprochée d'une différence de température $\Delta\Theta$ entre les surfaces interne et externe de ladite au moins une couche de matériau (i.e. aux bornes de cette couche de matériau).

Dans l'application du câble électrique 10, les températures aux bornes de la résistance thermique T1 sont d'une part la température du conducteur $\Theta_{cond}$ et d'autre part la température périphérique $\Theta_{b1}$. Ainsi, la différence de température $\Delta\Theta$ s'exprime comme suit : $\Delta\Theta = \Theta_{cond} - \Theta_{b1}$.

Selon ce modèle physique, une relation mathématique est établie entre flux thermique $W_c$, la résistance thermique T1 et la différence de température $\Delta\Theta$ aux bornes de cette résistance thermique. Cette relation est la suivante :

$$\Delta\Theta = T_1 * W_c$$

avec

$\Delta\Theta$ étant la différence de température $\Delta\Theta$ entre les surfaces interne et externe de couche de ladite au moins une couche de matériau,

$T_1$ étant la résistance thermique de ladite au moins une couche de matériau, $W_c$ étant le flux thermique généré par l'échauffement du conducteur.

La température de conducteur $\Theta_{cond}$ peut donc s'exprimer comme suit :

$$\Theta_{cond} = \Theta_{b1} + W_c * T_1$$

avec

$\Theta_{cond}$ étant la température de conducteur,
$\Theta_{b1}$ étant la température périphérique.

La résistance thermique $T_1$ de ladite au moins une couche de matériau est déterminée comme suit :

$$T_1 = \frac{\rho_T}{2 \times \pi} \ln(1 + 2 * \frac{t_1}{d_c})$$

avec

$\rho_T$ étant la conductivité thermique de ladite au moins une couche de matériau,
$d_c$ étant le diamètre interne de ladite au moins une couche de matériau,
$t_1$ étant l'épaisseur de ladite au moins une couche de matériau.

Le modèle physique comprend deux modes de détermination de la température de conducteur $\Theta_{cond}$.
Dans le premier mode de détermination, le système de détermination 100 comprend un dispositif de mesure de l'intensité électrique $I_{cond}$ d'un courant électrique circulant dans ledit au moins un conducteur électrique 12.
Le dispositif de mesure est un dispositif non-invasif, notamment du type d'un enroulement de Rogowski.
Dans le deuxième mode de détermination, le système de détermination 100 comprend au moins une couche additionnelle 24 de matériau et au moins un capteur de température additionnel 26.
Ce deuxième mode de détermination permet de s'affranchir de l'utilisation de l'intensité électrique $I_{cond}$ du courant circulant dans le conducteur.
Ladite au moins une couche additionnelle de matériau 24 est disposée autour de ladite au moins une couche de matériau. La ou les couches additionnelles de matériau 24 recouvre ledit au moins un capteur de température 22, tel que visible sur la figure 4.
Ces deux modes de détermination peuvent être utilisés pour la détermination de la température de conducteur $\Theta_{cond}$ selon différentes modélisations d'un câble électrique 10. Ces différentes modélisations peuvent impliquer différentes hypothèses (e.g. prise en compte ou non de pertes diélectriques) ou bien différentes configurations du câble électrique 10.
L'unité de détermination 22 est configuré pour mettre en œuvre le premier et/ou le deuxième modes de détermination. L'unité de détermination 22 est configurée pour déterminer la température de conducteur $\Theta_{cond}$ selon l'une ou plusieurs modélisations, notamment l'une ou plusieurs parmi les modélisations présentées ci-après.

**Câble électrique sans écran et sans prise en compte des pertes diélectriques**

L'unité de détermination 22 est configurée pour déterminer la température de conducteur $\Theta_{cond}$ selon une première et une deuxième modélisations respectivement illustrées sur les figures 3 et 5.
Plus spécifiquement, l'unité de détermination 22 est configurée pour la température de conducteur $\Theta_{cond}$ selon la première modélisation au moyen du premier mode de détermination. L'unité de détermination 22 est configurée pour la température de conducteur $\Theta_{cond}$ selon la deuxième modélisation au moyen du deuxième mode de détermination.
Dans les première et deuxième modélisations, les pertes diélectriques dans ladite au moins une couche de matériau ne sont pas prises en compte ou considérées comme minimes.
Dans ces première et deuxième modélisations, le câble électrique 10 est dépourvu d'écran.
La première modélisation s'applique à câble électrique 10 comprenant un conducteur électrique 12 et une ou plusieurs couches de matériau entourant le conducteur électrique 12. Un ou plusieurs capteurs de température 20 sont disposés sur la surface externe 18 de ladite au moins une couche de matériau.
Le câble électrique 10 selon la figure 2 est un exemple compatible avec cette première modélisation.
Tel qu'indiqué ci-avant, la température de conducteur $\Theta_{cond}$ peut s'exprimer comme suit :

$$\Theta_{cond} = \Theta_{b1} + W_c * T_1$$

avec

$\Theta_{cond}$ étant la température de conducteur,
$\Theta_{b1}$ étant la température périphérique,
$T_1$ étant la résistance thermique de ladite au moins une couche de matériau,
$W_c$ étant le flux thermique généré par l'échauffement du conducteur.

Selon le premier mode de détermination, on exprime le flux thermique Wc dû à l'échauffement du conducteur électrique 12 comme suit :

$$W_c = R_c * I_{cond}^2$$

$R_c$ étant la résistance électrique du conducteur électrique,
$I_{cond}$ étant l'intensité du courant circulant le long du conducteur électrique.

La température de conducteur $\Theta_{cond}$ selon le premier mode de détermination, i.e. fonction de l'intensité du conducteur électrique, s'exprime donc comme suit :

$$\Theta_{cond} = \Theta_{b1} + R_c * I_{cond}^2 * T_1$$

La résistance électrique Rc du conducteur électrique s'exprime comme suit :

$$R_c = R_0 \times \left(1 + \alpha_{20} \times (\Theta_{cond} - 20)\right) \times \left(1 + y_s + y_p\right)$$

avec

$R_0$ étant la résistance en courant continu du conducteur à 20°C, en Ohm,
$Y_s$ étant le facteur d'effet de peau, sans unité,
$Y_p$ étant le facteur d'effet de proximité, sans unité,
$\alpha_{20}$ étant le coefficient de résistivité électrique, en $K^{-1}$ (i.e. par kelvin).

Les paramètres $R_0$, $Y_s$, $Y_p$ et $\alpha_{20}$ sont des valeurs liées à la structure et la nature du conducteur électrique.
La température de conducteur $\Theta_{cond}$ peut ainsi s'exprimer comme suit :

$$\Theta_{cond} = \frac{\Theta_{b1} - R_0^2 \times T_1 \times (1 - 20 \times \alpha_{20})}{1 - R_0 \times I_{cond}^2 \times \alpha_{20} \times T_1}$$

Selon le deuxième mode de détermination, i.e. sans l'intensité du conducteur $I_{cond}$, l'unité de détermination 100 comprend une structure additionnelle illustrée en figure 4. Ainsi, le système de détermination 100 comprend au moins une couche additionnelle 24 de matériau et au moins un capteur de température additionnel 26.
Ladite au moins une couche additionnelle de matériau 24 présente une résistance thermique additionnelle $T_b$.
Ladite au moins une couche additionnelle de matériau 24 est par exemple au moins une couche isolante électriquement.
Le matériau de ladite au moins une couche additionnelle de matériau 24 présente de préférence une résistance thermique entre 0,001 $m^2$.K/W et 0,1 $m^2$.K/W. Dans cette plage de résistance thermique, ladite au moins une couche de matériau 24permet d'éviter la surchauffe du conducteur tout permettant une différence de température suffisamment grande pour être mesurée.
Ledit au moins un capteur de température additionnel 26 permet de mesurer une température périphérique additionnelle $\Theta_{b2}$ au niveau de la surface externe 28 de ladite au moins une couche additionnelle de matériau 24.
Le système de détermination 100 peut comprendre une pluralité de capteurs de température additionnels 26 répartis autour de l'axe longitudinal A dans un même plan transversal à l'axe longitudinal A. Dans l'exemple de la figure 4, le système de détermination 100 comprend 9 capteurs de température additionnels 26.
Le ou les capteurs de température additionnels 26 sont connectés à l'unité de détermination 22 de manière à communiquer la température périphérique additionnelle $\Theta_{b2}$ à cette unité de détermination 22.
De préférence, les capteurs de température additionnels 26 sont équirépartis autour de l'axe longitudinal A. Le système de détermination 100 peut prévoir un ou plusieurs capteurs de température additionnels 26 répartis en outre le long de l'axe longitudinal A de manière à mesurer la température périphérique additionnelle $\Theta_{b2}$ à différentes localisations le long du câble électrique 10.
De préférence, le nombre et/ou la position angulaire et/ou la position longitudinale des capteurs de température 20 sont respectivement identiques au nombre et/ou à la position angulaire et/ou la position longitudinale des capteurs de température additionnels 26.
Le câble électrique 10 équipé de ladite au moins une couche additionnelle de matériau 24 et dudit au moins un capteur de température additionnel 26 est modélisé par une deuxième modélisation sur la figure 5. Ladite au moins une couche additionnelle de matériau 24 est considérée comme une résistance de valeur $T_b$ en série avec la résistance de valeur $T_1$ correspondant à ladite au moins une couche de matériau.

Selon ce deuxième mode de détermination, on exprime le flux thermique $W_c$ commet suit :

$$W_c = \frac{(\Theta_{b1} - \Theta_{b2})}{T_b}$$

La température de conducteur peut ainsi être exprimée comme suit :

$$\theta_{cond} = \theta_{b1} + \frac{(\theta_{b1} - \theta_{b2})}{T_b} \times T_1$$

La détermination de la température de conducteur $\Theta_{cond}$ peut ainsi être déterminée sans nécessiter la valeur de l'intensité du courant circulant dans le conducteur électrique 12. Cette détermination est rendue possible par l'adjonction d'une couche additionnelle et d'un capteur additionnel.

**Câble électrique sans écran et avec prise en compte des pertes diélectriques**

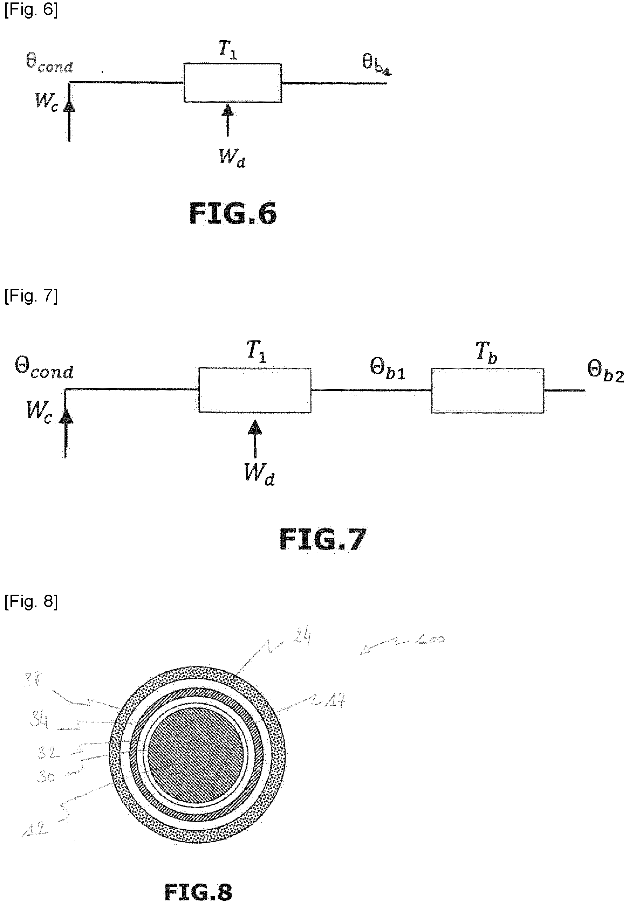

L'unité de détermination 22 est configurée pour déterminer la température de conducteur $\Theta_{cond}$ selon une troisième et une quatrième modélisations respectivement illustrées sur les figures 6 et 7.

Plus spécifiquement, l'unité de détermination 22 est configurée pour déterminer la température de conducteur $\Theta_{cond}$ selon la troisième modélisation au moyen du premier mode de détermination. L'unité de détermination 22 est configurée pour la température de conducteur $\Theta_{cond}$ selon la quatrième modélisation au moyen du deuxième mode de détermination.

Dans les troisième et quatrième modélisations, les pertes diélectriques dans ladite au moins une couche de matériau sont prises en compte.

Dans ces troisième et quatrième modélisations, le câble électrique 10 est dépourvu d'écran.

Dans ces troisième et quatrième modélisations, les pertes diélectriques dans ladite au moins une couche de matériau sont considérées comme un flux thermique de perte $W_d$ au niveau de la résistance de valeur $T_1$ correspondant à ladite au moins une couche de matériau. Ce flux thermique de perte $W_d$ est visible sur les figures 6 et 7.

La troisième modélisation s'applique à câble électrique 10 comprenant un conducteur électrique 12 et une ou plusieurs couches de matériau entourant le conducteur électrique 12. Un ou plusieurs capteurs de température 20 sont disposés sur la surface externe 18 de ladite au moins une couche de matériau.

Le câble électrique 10 selon la figure 2 est un exemple compatible avec cette troisième modélisation.

Selon le premier mode de détermination, la température de conducteur $\Theta_{cond}$ peut s'exprimer comme suit en fonction de l'intensité électrique $I_{cond}$ :

$$\theta_{cond} = \theta_{b1} + T_1 \times \left( W_c - \frac{W_d}{2} \right)$$

Cette température de conducteur $\Theta_{cond}$ peut également s'exprimer comme suit en décomposant $R_c$ tel que décrit ci-avant :

$$\theta_{cond} = \frac{\theta_{b1} - (R_0 I_{cond}^2) T_1 (1 - 20 \times \alpha_{20}) + \frac{1}{2} T_1 W_d}{1 - R_0 I_{cond}^2 \alpha_{20} T_1}$$

Selon le deuxième mode de détermination, i.e. sans l'intensité du conducteur $I_{cond}$, l'unité de détermination 100 comprend une structure additionnelle telle qu'illustrée en figure 4. Ainsi, le système de détermination 100 comprend au moins une couche additionnelle 24 de matériau et au moins un capteur de température additionnel 26.

Le câble électrique 10 équipé de ladite au moins une couche additionnelle de matériau 24 et dudit au moins un capteur de température additionnel 26 est modélisé par une quatrième modélisation sur la figure 7.

Ladite au moins une couche additionnelle de matériau 24 est considérée comme une résistance de valeur $T_b$ en série avec la résistance de valeur $T_1$ correspondant à ladite au moins une couche de matériau.

Selon ce deuxième mode de détermination, on exprime la température de conducteur $\Theta_{cond}$ comme suit :

$$\theta_{cond} = \theta_{b1} + T_1 \times \left( \frac{(\theta_{b1} - \theta_{b2})}{T_b} - \frac{W_d}{2} \right)$$

L'équation précédente est obtenue en considérant les équations suivantes :

$$\theta_{cond} = \theta_{b1} + T_1 \times \left( W_c + \frac{W_d}{2} \right)$$

et

$$\theta_{b1} = \theta_{b2} + T_b \times (W_d + W_c)$$

Le flux thermique de perte $W_d$ est déterminé en fonction de la tension appliquée au conducteur électrique 12, de la fréquence de la tension appliquée au conducteur électrique 12 et des caractéristiques diélectriques de ladite au moins une couche de matériau.

**Câble électrique avec écran et prise en compte des pertes diélectriques**

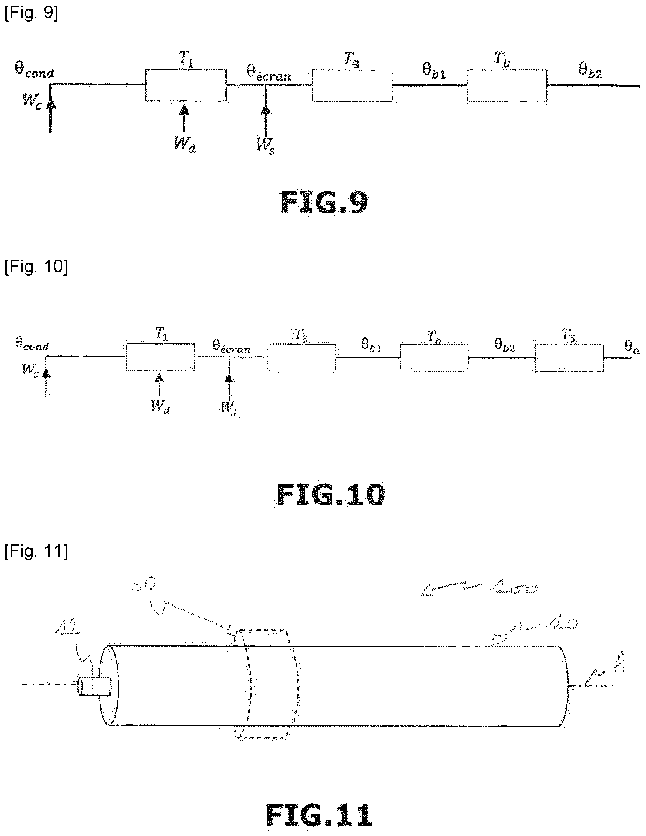

L'unité de détermination 22 est en outre configurée pour déterminer la température de conducteur $\Theta_{cond}$ dans une configuration du câble électrique 10 comprenant un écran 17.
Tel qu'illustré en figure 8, le câble électrique 10 comprend un conducteur électrique 12, une ou plusieurs couches de matériau entourant le conducteur électrique 12 et un écran 17 entourant lesdites couches de matériau.
Lesdites couches de matériau sont par exemple une couche diélectrique 30 entourant le conducteur électrique 12 et une couche isolante 32 disposée entre la couche diélectrique 30 et l'écran 17.
Le câble électrique 10 comprend également une couche externe 34, par exemple une gaine externe, définissant une surface externe 38 de la couche externe 34. La couche externe 34 peut comprendre une pluralité de couches de matériau.
La couche externe 34 présente une résistance thermique $T_3$.
Un ou plusieurs capteurs de température 20 sont disposés sur la surface externe 38 de la couche externe 34.
Des pertes dans l'écran 17 sont modélisées par un flux thermique d'écran $W_s$. Ces pertes sont dues à un échauffement par effet joule dans l'écran 17.
La détermination du flux thermique d'écran $W_s$ requiert une mesure invasive sur le câble électrique 10. Pour s'affranchir d'exprimer la température de conducteur $\Theta_{cond}$ en fonction du flux thermique $W_s$, il est ici proposé de combiner les premier et deuxième modes de détermination vu précédemment. En d'autres termes, il est prévu ici d'exprimer la température de conducteur $\Theta_{cond}$ en fonction de l'intensité $I_{cond}$ de la tension circulant dans le conducteur électrique 12 et d'utiliser une structure additionnelle comprenant au moins une couche additionnelle de matériau 24 et au moins un capteur de température additionnel 26, tel que visible sur la figure 8.
Ladite au moins une couche additionnelle de matériau 24 présente une résistance thermique $T_b$.
Une cinquième modélisation est illustrée à la figure 9 prenant en compte les pertes d'écran (flux thermique $W_s$) ainsi que les pertes diélectriques dans ladite au moins une couche (flux thermique $W_d$) et comprenant trois résistances en série pour modéliser les résistances thermiques de ladite au moins une couche de matériau ($T_1$), de la gaine externe 34 ($T_3$) et de ladite au moins une couche additionnelle de matériau 24 ($T_b$).
Dans cette cinquième modélisation, la température de conducteur $\Theta_{cond}$ s'exprime comme suit :

$$\theta_{cond} = \frac{\theta_{b1} + T_3 \frac{\Delta\theta_b}{T_b} + \frac{1}{2}T_1 W_d - (R_0 I^2)T_1(1 - 20 \times \alpha_{20})}{1 - R_0 I_{cond}^2 \alpha_{20} T_1}$$

$\Theta_{b1}$ étant la température périphérique mesurée par ledit au moins un capteur de température 20,
$\Theta_{b2}$ étant la température périphérique additionnelle mesurée par ledit au moins un capteur de température additionnel 26,
$\Delta\Theta$ étant la différence de température $\Theta_{b1}$ - $\Theta_{b2}$,
$T_1$ étant la résistance thermique de ladite au moins une couche de matériau,

$T_b$ étant la résistance thermique de ladite au moins une couche additionnelle de matériau 24,

$T_3$ étant la résistance thermique de couche externe 34,

$R_0$ étant la résistance en courant continu du conducteur à 20°C, en Ohm,

$Y_s$ étant le facteur d'effet de peau, sans unité,

$Y_p$ étant le facteur d'effet de proximité, sans unité,

$\alpha_{20}$ étant le coefficient de résistivité électrique, en K$^{-1}$ (i.e. par kelvin).

L'unité de détermination 22 est ainsi capable de déterminer la température de conducteur $\Theta_{cond}$ indépendamment du flux thermique d'écran $W_s$.

Cette expression de la température de conducteur $\Theta_{cond}$ est obtenue en considérant que :

$$\theta_{cond} = \theta_{surf} + n(W_c + W_s + W_d)T_3 + \left(W_c + \frac{W_d}{2}\right)T_1$$

$$n(W_c + W_s + W_d) = \frac{\Delta\theta_b}{T_b}$$

$$\theta_{conducteur} = \theta_{b1} + T_3\frac{\Delta\theta_b}{T_b} + \left(W_c + \frac{W_d}{2}\right)T_1$$

avec $\Theta_{surf}$ étant la température périphérique au niveau de la surface externe du câble électrique 10, et

n étant le nombre de conducteurs électriques 12.

Tel que détaillé précédemment, la résistance thermique $T_1$ est déterminée comme suit :

$$T_1 = \frac{\rho_T}{2 \times \pi}\ln(1 + 2 * \frac{t_1}{d_c})$$

La résistance thermique $T_3$ de la couche externe 34 est déterminée comme suit :

$$T_3 = \frac{\rho_T}{2 \times \pi}\ln(1 + 2 * \frac{t_3}{D_a})$$

avec

$t_3$ étant l'épaisseur de la couche externe 34,

$D_a$ étant le diamètre interne de la couche externe 34.

Selon une sixième modélisation illustrée en figure 10, l'unité de détermination est également configurée pour déterminer la température de conducteur $\Theta_{cond}$ de manière indépendante du milieu environnant, notamment de la température de ce milieu environnant.

Cette sixième modélisation s'applique à la même configuration de câble électrique 10 que la cinquième modélisation. En d'autres termes, la sixième modélisation s'applique à un câble électrique du type de celui de la figure 8 avec une structure additionnelle et un écran 17.

Selon le milieu environnant, la chaleur va être plus ou moins bien évacuée du câble électrique 10. Le milieu environnant est modélisé par une couche de matériau avec une certain résistance thermique $T_5$ et une température $\theta_a$ correspondant à la température ambiante du milieu environnant.

La température de conducteur $\Theta_{cond}$ peut s'exprimer ainsi :

$$\theta_{cond} = \theta_a + \left(W_c + \frac{W_d}{2}\right)T_1 + n(W_c + W_d + W_s)T_3 + n(W_c + W_d + W_s)T_b + n(W_c + W_d + W_s)T_5$$

La différence de température $\Theta_{b1} - \Theta_{b2}$ de part et d'autre de la couche additionnelle de matériau 24 permet d'exprimer la température de conducteur $\Theta_{cond}$ comme suit :

$$\theta_{cond} = \theta_{b1} + \left(W_c + \frac{W_d}{2}\right)T_1 + n(W_c + W_d + W_s)T_b$$

et

$$\theta_{b1} - \theta_{b2} = n(W_c + W_d + W_s)T_b$$

La température de conducteur $\Theta_{cond}$ peut ainsi être déterminée par l'unité de détermination 22 indépendamment du milieu environnant.

En référence à la figure 11, le système de détermination 100 peut comprendre un boîtier de détermination 50 dans lequel sont logés l'un ou plusieurs parmi ledit au moins un capteur de température 20.

L'unité de détermination 22 est de préférence portée par le boîtier de détermination 50. Si l'unité de détermination est déportée par rapport au boîtier de détermination 50, le boîtier de détermination 50 est configuré pour communiquer des informations, notamment des mesures de capteur, à l'unité de détermination 22.

Ce boîtier de détermination 50 est par exemple amovible par rapport au câble électrique 10 de manière à réaliser une mesure ponctuelle et localisée sur le câble électrique 10. Ce boîtier est par exemple un accessoire de mesure portable.

Le boîtier de détermination 50 présente une dimension suivant l'axe longitudinal A de sorte qu'il s'étend uniquement sur une portion de la longueur du câble électrique 10.

Le boîtier de détermination 50 peut également comprendre la structure additionnelle. En d'autres termes, le boîtier de détermination 50 peut également comprendre ladite au moins une couche additionnelle de matériau 24 et ledit au moins un capteur de température additionnel 26.

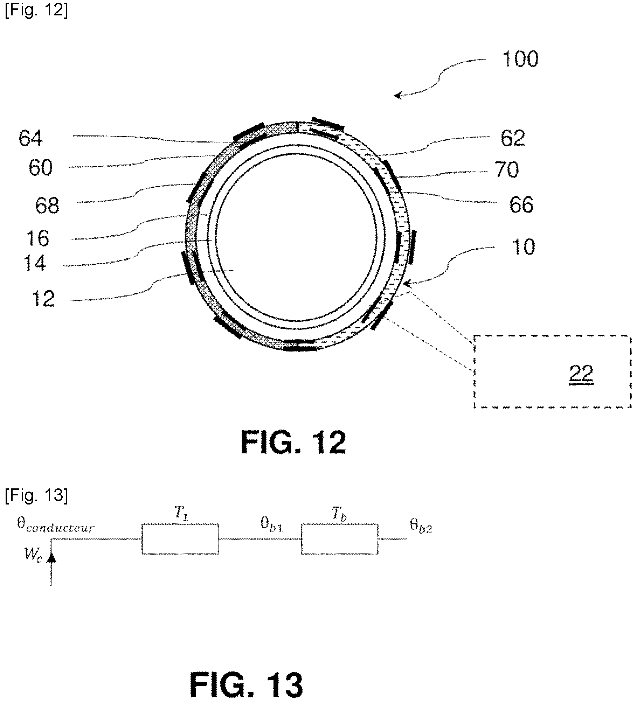

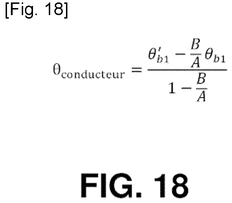

En lien avec les figures 12 à 18, l'unité de détermination 22 est en outre configurée pour déterminer la température de conducteur $\Theta_{cond}$ selon une septième et une huitième modélisations.

Dans septième et huitième modélisations, l'unité de détermination 22 est configurée pour déterminer la température de conducteur $\Theta_{cond}$ sans nécessiter de détermination du flux thermique $W_c$ généré par la circulation d'un courant électrique dans le conducteur électrique.

Pour ces septième et huitième modélisations, le système de détermination 100 est semblable à celui de la figure 4 avec pour différence que ladite au moins une couche additionnelle 24 comprend une première 60 et une deuxième 62 portions de couche additionnelle, tel qu'illustré en figure 12.

La première portion de couche additionnelle 60 présente une première résistance thermique additionnelle $T_b$ La deuxième portion de couche additionnelle 62 présente une deuxième résistance thermique additionnelle $T'_b$. Les première $T_b$ et deuxième $T'_b$ résistances thermiques additionnelles sont différentes.

Cette différence entre les première $T_b$ et deuxième $T'_b$ résistances thermiques additionnelles peut être obtenue par utilisation d'un matériau différent et/ou d'une ou plusieurs caractéristiques géométriques différentes entre les première 60 et deuxième 62 portions de couche additionnelle. Un exemple de caractéristique géométrique différente est une épaisseur différente, prise le long d'un axe perpendiculaire à l'axe longitudinal d'extension A du conducteur électrique.

Cette différence entre les première $T_b$ et deuxième $T'_b$ résistances thermiques additionnelles permet de construire deux équations différentes ayant pour inconnue la température de conducteur $\Theta_{cond}$. Il est ainsi possible de s'affranchir de la connaissance du flux thermique $W_c$

Une pluralité de premiers capteurs de température 64 sont disposés sur la surface externe 18 de ladite au moins une couche de matériau, entre ladite surface externe 18 et la première portion de couche additionnelle 60. La pluralité de premiers capteurs de température 64 permettent de mesurer une première température périphérique $\Theta_{b1}$ au niveau de la surface externe 18 de ladite au moins une couche de matériau.

Une pluralité de deuxièmes capteurs de température 66 sont disposés sur la surface externe 18 de ladite au moins une couche de matériau, entre ladite surface externe 18 et la deuxième portion de couche additionnelle 62. La pluralité de deuxièmes capteurs de température 66 permettent de mesurer une deuxième température périphérique $\Theta'_{b1}$ au niveau de la surface externe 18 de ladite au moins une couche de matériau.

Une pluralité de premiers capteurs de température additionnels 68 sont disposés sur une surface externe de la première portion de couche additionnelle 60 pour mesurer une première température périphérique additionnelle $\Theta_{b2}$.

Une pluralité de deuxièmes capteurs de température additionnels sont disposés sur une surface externe de la deuxième portion de couche additionnelle pour mesurer une deuxième température périphérique additionnelle $\Theta'_{b2}$.

L'unité de détermination 22 est configurée pour déterminer la température de conducteur $\Theta_{cond}$ en outre en fonction de la première $T_b$ et de la deuxième $T'_b$ résistances thermiques additionnelles ainsi que de la première $\Theta_{b2}$ et de la deuxième $\Theta'_{b2}$ températures périphériques additionnelles.

**Câble électrique sans écran sans prise en compte des pertes diélectriques**

La septième modélisation est illustrée dans les figures 13 à 15.

Dans la septième modélisation, la température de conducteur $\Theta_{cond}$ s'exprime comme ci-après:

$$\theta_{conducteur} = \frac{(\theta_{b1}T_b - \theta'_{b1}T'_b) \times ((\theta_{b1} - \theta_{b2}))}{T_b(\theta'_{b1} - \theta'_{b2}) - T'_b(\theta_{b1} - \theta_{b2})}$$

Cette équation est obtenue via les développements suivant :

$$\frac{(\theta_{conducteur} - \theta_{b1})}{T_1} = \frac{(\theta_{b1} - \theta_{b2})}{T_b}$$

$$\frac{(\theta_{conducteur} - \theta'_{b1})}{T_1} = \frac{(\theta''_{b1} - \theta'_{b2})}{T'_b}$$

$$(\theta_{conducteur} - \theta_{b1})\frac{T_b}{(\theta_{b1} - \theta_{b2})} = (\theta_{conducteur} - \theta'_{b1})\frac{T'_b}{(\theta''_{b1} - \theta'_{b2})}$$

$$\theta_{conducteur} = \frac{\theta_{b1}T_b - \theta'_{b1}T'_b}{(\theta'_{b1} - \theta'_{b2})} / (\frac{T_b}{(\theta_{b1} - \theta_{b2})} - \frac{T'_b}{(\theta'_{b1} - \theta'_{b2})})$$

**Câble électrique sans écran** avec **prise** en compte des pertes diélectriques

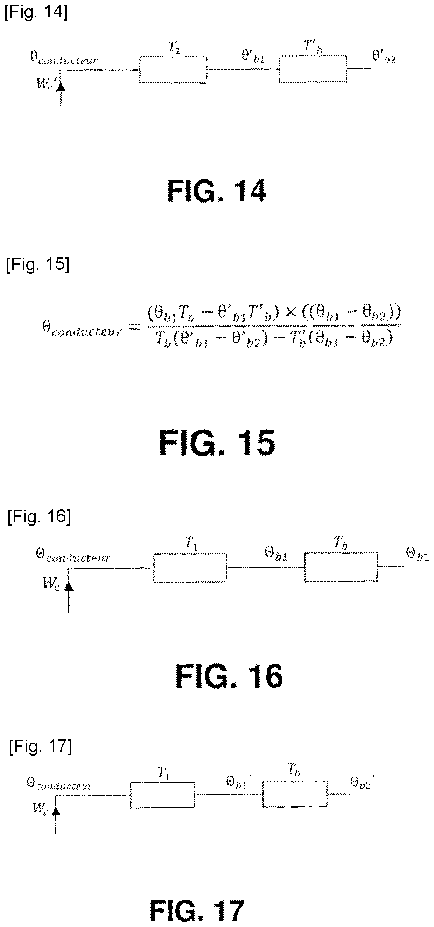

La huitième modélisation est illustrée dans les figures 16 à 18.

Dans la huitième modélisation, la température de conducteur $\Theta_{cond}$ s'exprime comme ci-après:

$$\theta_{conducteur} = \frac{\theta'_{b1} - \frac{B}{A}\theta_{b1}}{1 - \frac{B}{A}}$$

Cette équation est obtenue via les développements suivant :

$$\theta_{conducteur} = \theta_{b1} + T_1 \times \left(\frac{(\theta_{b1} - \theta_{b2})}{T_b} - \frac{W_d}{2}\right)$$

$$\theta_{conducteur} = \theta_{b1}' + T_1 \times \left(\frac{(\theta_{b1}' - \theta_{b2}')}{T_b'} - \frac{W_d}{2}\right)$$

$$A = \left(\frac{(\theta_{b1} - \theta_{b2})}{T_b} - \frac{W_d}{2}\right)$$

$$B = \left(\frac{(\theta_{b1}' - \theta_{b2}')}{T_b'} - \frac{W_d}{2}\right)$$

$\Theta_{b1}'$ étant la première température périphérique au niveau de la surface externe 18 de ladite au moins une couche de

matériau,

$\Theta_{b2}$' étant la deuxième température périphérique additionnelle,

$T_b$' étant la deuxième résistance thermique additionnelle.

## Revendications

1.  Système de détermination (100) non-invasive d'une température d'un conducteur d'un câble électrique, comprenant :

    - un câble électrique (10) comprenant au moins un conducteur électrique (12) et au moins une couche de matériau (14, 16, 17, 30, 32, 34) entourant ledit au moins un conducteur, ladite au moins une couche présentant une résistance thermique de couche $T_1$,
    - au moins un capteur de température (20) disposé sur une surface externe (18) de ladite au moins une couche de matériau pour mesurer une température périphérique $\Theta_{b1}$ au niveau de la surface externe de ladite au moins une couche de matériau,
    - une unité de détermination (22) configurée pour déterminer une température de conducteur $\Theta_{cond}$ en fonction de la température périphérique $\Theta_{b1}$ mesurée et la résistance thermique de couche $T_1$.

2.  Système de détermination (100) la revendication précédente, comprenant en outre :

    - au moins une couche additionnelle de matériau disposée autour de ladite au moins une couche de matériau et recouvrant ledit au moins un capteur de température, ladite couche additionnelle de matériau présentant une résistance thermique additionnelle $T_b$,
    - au moins un capteur de température additionnel disposé sur une surface externe de ladite couche de matériau additionnelle pour mesurer une température périphérique additionnelle $\Theta_{b2}$ au niveau de la surface externe de ladite au moins une couche additionnelle de matériau.

3.  Système de détermination (100) selon la revendication précédente, dans lequel ladite couche additionnelle de matériau s'étend autour de ladite au moins une couche de matériau uniquement sur une portion de la longueur du câble électrique.

4.  Système de détermination (100) selon la revendication 2 ou 3, dans lequel ladite au moins une couche additionnelle de matériau comprend :

    - une première portion de couche additionnelle présentant une première résistance thermique additionnelle $T_b$, et
    - une deuxième portion de couche additionnelle présentant une deuxième résistance thermique additionnelle $T'_b$,
    les première $T_b$ et deuxième $T'_b$ résistances thermiques additionnelles étant différentes,
    et dans lequel ledit au moins un capteur de température additionnel comprend :

      - au moins un premier capteur de température additionnel disposé sur une surface externe de la première portion de couche additionnelle pour mesurer une première température périphérique additionnelle $\Theta_{b2}$,
      - au moins un deuxième capteur de température additionnel disposé sur une surface externe de la deuxième portion de couche additionnelle pour mesurer une deuxième température périphérique additionnelle $\Theta'_{b2}$,

    l'unité de détermination étant configurée pour déterminer la température de conducteur $\Theta_{cond}$ en outre en fonction de la première $T_b$ et de la deuxième $T'_b$ résistances thermiques additionnelles ainsi que de la première $\Theta_{b2}$ et de la deuxième $\Theta'_{b2}$ températures périphériques additionnelles.

5.  Système de détermination (100) selon la revendication précédente, dans lequel lesdites au moins une première et au moins une deuxième couches additionnelles sont disposées sur des secteurs angulaires différents autour du conducteur électrique.

6.  Système de détermination (100) selon la revendication précédente, dans lequel ledit au moins un capteur de température (20) comprend :

    - au moins un premier capteur disposé sur la surface externe (18) de ladite au moins une couche de matériau, entre ladite surface externe (18) et la première portion de couche additionnelle, pour mesurer une température périphérique $\Theta_{b1}$ au niveau de la surface externe de ladite au moins une couche de matériau,

- au moins un deuxième capteur disposé sur la surface externe (18) de ladite au moins une couche de matériau, entre ladite surface externe (18) et la deuxième portion de couche additionnelle, pour mesurer une température périphérique $\Theta'_{b1}$ au niveau de la surface externe de ladite au moins une couche de matériau.

7. Système de détermination (100) selon la revendication précédente, dans lequel l'unité de détermination est configurée pour déterminer la température de conducteur $\Theta_{cond}$ sur la base de l'équation suivante :

$$\theta_{conducteur} = \frac{(\theta_{b1}T_b - \theta'_{b1}T'_b) \times ((\theta_{b1} - \theta_{b2}))}{T_b(\theta'_{b1} - \theta'_{b2}) - T'_b(\theta_{b1} - \theta_{b2})}$$

$T_1$ étant la résistance thermique de ladite au moins une couche de matériau,
$T_b$ étant la première résistance thermique additionnelle de la première couche additionnelle de matériau,
$T'_b$ étant la deuxième résistance thermique additionnelle de la deuxième couche additionnelle de matériau,
$\Theta_{b1}$ est la température périphérique mesurée par ledit au moins un premier capteur de température,
$\Theta_{b2}$ est la température périphérique additionnelle mesurée par ledit au moins un premier capteur de température additionnel,
$\Theta'_{b1}$ est la température périphérique mesurée par ledit au moins un deuxième capteur de température,
$\Theta'_{b2}$ est la température périphérique additionnelle mesurée par ledit au moins un deuxième capteur de température additionnel.

8. Système de détermination (100) selon l'une quelconque des revendications 4 à 7, dans lequel les première et deuxième portions de couche additionnelle sont réalisées dans un matériau différent.

9. Système de détermination (100) selon l'une quelconque des revendications 4 à 8, dans lequel les première et deuxième portions de couche additionnelle présentent une épaisseur différente, prise perpendiculairement à un axe longitudinal d'extension du câble électrique (10).

10. Système de détermination (100) selon l'une quelconque des revendications précédentes, dans lequel ladite au moins une couche de matériau comprend une gaine externe formant ladite surface externe, ledit au moins un capteur de température étant disposé sur ladite gaine externe.

11. Système de détermination (100) selon l'une quelconque des revendications précédentes, dans lequel l'unité de détermination est configurée pour déterminer la température de conducteur $\Theta_{cond}$ en fonction du flux thermique $W_c$ généré par la circulation d'un courant électrique dans le conducteur électrique, sur la base de l'équation suivante :

$$\Theta_{cond} = \Theta_{b1} + W_c {}^* T_1$$

12. Système de détermination (100) selon l'une quelconque des revendications précédentes, comprenant en outre un dispositif de mesure de l'intensité électrique $I_{cond}$ d'un courant électrique circulant dans ledit au moins un conducteur électrique, l'unité de détermination étant configurée pour déterminer ladite température de conducteur $\Theta_{cond}$ en outre en fonction de cette intensité électrique $I_{cond}$.

13. Système de détermination (100) selon la revendication précédente, dans lequel le dispositif de mesure est un dispositif non-invasif, notamment du type d'un enroulement de Rogowski.

14. Système de détermination (100) selon la revendication 12 ou 13, dans laquelle la température du conducteur $\Theta_{cond}$ est déterminée comme suit :

$$\Theta_{cond} = \Theta_{b1} + R_c {}^* I_{cond}{}^2 {}^* T_1$$

$R_c$ étant la résistance électrique du conducteur,
$I_{cond}$ étant le courant électrique circulant dans ledit au moins un conducteur électrique.

15. Système de détermination (100) selon l'une quelconque des revendications précédentes en combinaison avec la revendication 2, dans lequel ladite couche additionnelle de matériau s'étend autour de ladite au moins une couche de matériau uniquement sur une portion de la longueur du câble électrique.

**16.** Système de détermination (100) selon l'une quelconque des revendications précédentes en combinaison avec la revendication 2, dans lequel l'unité de détermination est configurée pour déterminer la température de conducteur $\Theta_{cond}$ sur la base de l'équation suivante :

$$\theta_{cond} = \theta_{b1} + \frac{(\theta_{b1} - \theta_{b2})}{T_b} \times T_1$$

$\Theta_{b1}$ est la température périphérique mesurée par ledit au moins un capteur de température,

$\Theta_{b2}$ est la température périphérique additionnelle mesurée par ledit au moins un capteur de température additionnel,

$T_b$ étant la résistance thermique additionnelle de la couche additionnelle de matériau,

$T_1$ étant la résistance thermique de ladite au moins une couche de matériau.

**17.** Système de détermination (100) selon l'une quelconque des revendications précédentes, dans lequel l'unité de détermination est configurée pour déterminer la température de conducteur $\Theta_{cond}$ en outre en fonction d'un échauffement $W_d$ provenant d'une perte diélectrique dans ladite au moins une couche de matériau.

**18.** Système de détermination (100) selon la revendication précédente en combinaison avec l'une quelconque des revendications 12 à 14, dans lequel l'unité de détermination est configurée pour déterminer la température de conducteur $\Theta_{cond}$ sur la base de l'équation suivante :

$$\theta_{cond} = \theta_{b1} + T_1 \times \left(W_c + \frac{W_d}{2}\right)$$

$W_d$ étant l'échauffement provenant d'une perte diélectrique dans ladite au moins une couche de matériau.

**19.** Système de détermination (100) selon la revendication 17 en combinaison avec la revendication 2 ou 16, dans lequel l'unité de détermination est configurée pour déterminer la température de conducteur $\Theta_{cond}$ sur la base de l'équation suivante :

$$\theta_{cond} = \theta_{b1} + T_1 \times \left(\frac{\theta_{b1} - \theta_{b2}}{T_b} - \frac{W_d}{2}\right)$$

$W_d$ étant l'échauffement provenant d'une perte diélectrique dans ladite au moins une couche de matériau.

**20.** Système de détermination (100) selon l'une quelconque des revendications précédentes, comprenant en outre un boîtier de détermination comprenant l'un ou plusieurs parmi ledit au moins un capteur de température et l'unité de détermination, le boîtier étant configuré pour être monté de manière amovible au câble électrique.

**21.** Système de détermination (100) selon la revendication précédente en combinaison avec la revendication 2, dans laquelle ladite au moins une couche additionnelle de matériau et ledit au moins un capteur de température additionnel sont portés par le boîtier de détermination.

[Fig. 1]

**FIG.1**

[Fig. 2]

**FIG.2**

[Fig. 3]

$\theta_{cond.}$       $T_1$       $\theta_{b1}$

$W_c$

**FIG.3**

[Fig. 4]

**FIG.4**

[Fig. 5]

$\theta_{cond}$       $T_1$       $\theta_{b1}$       $T_b$       $\theta_{b2}$

$W_c$

**FIG.5**

[Fig. 6]

$\theta_{cond}$      $T_1$      $\theta_{b_4}$

$W_c$

$W_d$

# FIG.6

[Fig. 7]

$\Theta_{cond}$      $T_1$      $\Theta_{b1}$      $T_b$      $\Theta_{b2}$

$W_c$

$W_d$

# FIG.7

[Fig. 8]

38
34
32
30
12
24
100
17

# FIG.8

20

[Fig. 9]

$\theta_{cond}$ $T_1$ $\theta_{écran}$ $T_3$ $\theta_{b1}$ $T_b$ $\theta_{b2}$

$W_c$

$W_d$ $W_s$

# FIG.9

[Fig. 10]

$\theta_{cond}$ $T_1$ $\theta_{écran}$ $T_3$ $\theta_{b1}$ $T_b$ $\theta_{b2}$ $T_5$ $\theta_a$

$W_c$

$W_d$ $W_s$

# FIG.10

[Fig. 11]

# FIG.11

[Fig. 12]

FIG. 12

[Fig. 13]

FIG. 13

[Fig. 14]

$\theta_{conducteur}$ $W'_c$ $T_1$ $\theta'_{b1}$ $T'_b$ $\theta'_{b2}$

## FIG. 14

[Fig. 15]

$$\theta_{conducteur} = \frac{(\theta_{b1}T_b - \theta'_{b1}T'_b) \times ((\theta_{b1} - \theta_{b2}))}{T_b(\theta'_{b1} - \theta'_{b2}) - T'_b(\theta_{b1} - \theta_{b2})}$$

## FIG. 15

[Fig. 16]

$\Theta_{conducteur}$ $W_c$ $T_1$ $\Theta_{b1}$ $T_b$ $\Theta_{b2}$

## FIG. 16

[Fig. 17]

$\Theta_{conducteur}$ $W_c$ $T_1$ $\Theta_{b1}'$ $T_b'$ $\Theta_{b2}'$

## FIG. 17

[Fig. 18]

$$\theta_{\text{conducteur}} = \frac{\theta'_{b1} - \dfrac{B}{A}\theta_{b1}}{1 - \dfrac{B}{A}}$$

# FIG. 18

Europäisches
Patentamt

European
Patent Office

Office européen
des brevets

**RAPPORT DE RECHERCHE EUROPEENNE**

Numéro de la demande

EP 25 30 5113

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JP S60 233521 A (DENRIYOKU CHUO KENKYUSHO) 20 novembre 1985 (1985-11-20) * abrégé * * figures 1-3 * * le document en entier * ----- | 1-21 | INV. G01K1/143 G01K1/16 |
| X | EP 2 850 709 B1 (PSA AUTOMOBILES SA [FR]; CENTRE NAT RECH SCIENT [FR]) 25 mars 2020 (2020-03-25) * abrégé * * alinéas [0019], [0020], [0024] - [0026] * * figures 1,2 * ----- | 1-21 | |

**DOMAINES TECHNIQUES RECHERCHES (IPC)**

G01K

Le présent rapport a été établi pour toutes les revendications

| Lieu de la recherche | Date d'achèvement de la recherche | Examinateur |
|---|---|---|
| La Haye | 30 juin 2025 | Bagnera, Carlo |

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 30 5113

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-06-2025

| Document brevet cité au rapport de recherche | Date de publication | Membre(s) de la famille de brevet(s) | | Date de publication |
|---|---|---|---|---|
| JP S60233521 A | 20-11-1985 | JP | H0376694 B2 | 06-12-1991 |
| | | JP | S60233521 A | 20-11-1985 |
| EP 2850709 B1 | 25-03-2020 | CN | 104471814 A | 25-03-2015 |
| | | EP | 2850709 A1 | 25-03-2015 |
| | | FR | 2990807 A1 | 22-11-2013 |
| | | WO | 2013171251 A1 | 21-11-2013 |

EPO FORM P0460

Pour tout renseignement concernant cette annexe : voir Journal Officiel de l'Office européen des brevets, No.12/82